# EUROPÄISCHE PATENTANMELDUNG

(11) **EP 0 932 329 A1**
(43) Veröffentlichungstag der Anmeldung: **28.07.1999**
(21) Anmeldenummer: 99100466.4
(22) Anmeldetag: 12.01.1999
(51) Int. Cl.: H05K 5/02, G01P 1/02, F16B 5/10

(54) **Anordnung zum lösbaren Befestigen eines quaderförmigen, elektronischen Registriergerätes**

(30) Priorität: 22.01.1998 DE 29801003 U
(71) Anmelder: Mannesmann VDO Aktiengesellschaft, 60388 Frankfurt am Main (DE)
(72) Erfinder: Modest, Otmar Ing. grad., 78078 Niedereschach (DE); Busse, Andrea Dipl.-Ing., 78089 Unterkirchnach (DE); Gutsch, Werner Dipl.-Phys., 78126 Königsfeld (DE)

(57) **Zusammenfassung**

Bei einem Unfalldaten-Registriergerät, welches in der Regel in einem nicht leicht zugänglichen knautschsicheren Bereich eines Fahrzeuges angeordnet werden muß, ist es erforderlich, daß im Falle eines Unfalls ein relativ einfacher, gegebenenfalls werkzeugloser Ausbau erfolgen kann. Demzufolge wird vorgeschlagen mit dem Registriergerät (3) ein Renkelement (4) zu verbinden und in der dem Registriergerät (3) zugeordneten Montageplatte (10) dem Renkelement (4) entsprechende Freisparungen (25, 26, 27, 28) auszubilden.

## Beschreibung

Die Erfindung betrifft eine Anordnung zum lösbaren Befestigen eines quaderförmigen, elektronischen Registriergerätes mittels einer Montageplatte sowie an der Montageplatte und an dem Registriergerät vorgesehenen Kupplungsmitteln.

Handelt es sich bei dem gattungsgemäßen Registriergerät um einen beispielsweise in Kraftfahrzeugen eingesetzten Unfalldatenspeicher, so ist dieser wegen der stoßsensierenden Beschleunigungssensoren in dem betroffenen Fahrzeug im wesentlichen horizontal und in einem möglichst knautschsicheren Bereich des Fahrzeuges einzubauen. Diese Bedingungen schränken, abgesehen von sowohl praktischen als auch ästhetischen Belangen bei einem Einbau auf der Mittelkonsole, den möglichen Einbauort erheblich ein. Außerdem muß ein derartiges Registriergerät, um eine datengesicherte Auswertung vornehmen zu können, ausbaufähig sein, wobei insbesondere in der Unfallsituation auch ein Laie in der Lage sein sollte, den Ausbau vorzunehmen. Da aus den eingangs genannten Bedingungen nur ein Einbau des Registriergerätes unter dem Fahrer- oder Beifahrersitz oder unter den Rücksitzen in Betracht kommt, ist der jeweilige Einbauort relativ schwer zugänglich, so daß an die Einfachheit des Ausbaus hohe Ansprüche gestellt werden müssen.

Mit der EP 532 854 B1 wurde eine Befestigungsvorrichtung für ein Registriergerät der genannten Art bekannt, die vorsieht, daß an dem Registriergerät ein Träger und am Einbauort ein Halter befestigt werden.

Dabei stellen Träger und Halter stabile Blechteile dar, die mittels Zungen-Schlitz-Verbindungen in einer Ebene parallel zum Gehäuseboden zusammengefügt und in Fügerichtung mittels einer Schraube-Schlitzmutter-Verbindung miteinander verschraubt werden.

Die Lösung ist insofern ungünstig, weil das Zusammenfügen von Träger und Halter eine relativ feinfühlige Montage erforderlich macht und die vorgesehene Schraubverbindung am Einbauort in der Regel schlecht handhabbar ist und oft nur aus einer bestimmten Richtung vorgenommen werden kann. Verständlicherweise ist beim Ausbau des Gerätes, insbesondere in einer Paniksituation nach einem Unfall, das Lösen einer Schraubverbindung besonders ungünstig. Hinzu kommt, daß die Zungen-Schlitz-Verbindungen zwischen Träger und Halter als Keilverbindungen ausgebildet sind, um auch bei ungünstigen Toleranzlagen eine spielfreie und somit für den Fahrzeugeinsatz rüttelsichere Verbindung zu ermöglichen. Das heißt, daß beim Ausbau des Gerätes eine derartige Keilverbindung oft nur noch unter Anwendung eines Werkzeuges lösbar ist, der Einbauort die Handhabung eines Werkzeuges jedoch erheblich einschränkt. Ferner ist die Herstellung der für den Halter und den Träger vorgesehenen Stanz-Biegeteile relativ aufwendig.

Die Aufgabe der vorliegenden Erfindung bestand somit darin, die Montage des beschriebenen Registriergerätes zu verbessern, insbesondere den Ausbau des Registriergerätes so zu erleichtern, daß er werkzeuglos und gegebenenfalls mit einer Hand vorgenommen werden kann

Ziel der Erfindung ist es außerdem den Aufwand für die für die Montage erforderlichen Mittel zu verringern und eine für die Serienfertigung geeignete Ausführung zu schaffen.

Die Lösung der Aufgabe ist von Grundsatz her im Anspruch 1 beschrieben. Ein bevorzugtes Ausführungsbeispiel zeigt der Anspruch 2 auf. Vorteilhafte Ausgestaltungen des Ausführungsbeispiels gehen aus den dem Anspruch 2 folgenden Unteransprüchen hervor.

Die gefundene Anordnung löst die gestellte Aufgabe und bietet zusätzlich den Vorteil, daß infolge der speziellen Ausbildung der Renkverbindungsmittel, das Registriergerät bezogen auf die Montageplatte in verschiedenen Stellungen befestigt werden kann. Außerdem bietet die Ausbildung des Gehäuses des Registriegerätes derart, daß das Renkelement an gegenüberliegenden Wänden des Gehäuses befestigbar ist, die Möglichkeit, das Gehäuse am Einbauort zu wenden. Das heißt, die Einbaulage des Registriergerätes ist mit acht unterschiedlichen Stellungen vielseitig variierbar, so daß am Einbauort eine optimale Zugänglichkeit für den mit dem Registriergerät zu verbindenden Stecker gefunden werden kann. Hervorzuheben ist ferner, daß die Renkverbindung keine zusätzlichen Befestigungsmittel erfordert und daß nur eine Schraube für die zentrale und verdrehgesicherte Befestigung des Renkelementes an dem vorzugsweise quadratischen Gehäuse des Registriergerätes benötigt wird.

Im folgenden sei das bereits erwähnte Ausführungsbeispiel anhand von Zeichnungen näher erläutert. Es zeigen:
- Figur 1: eine Übersichtsdarstellung im Zustand der Montage des Registriergerätes, wobei die Montageplatte als Schnitt gemäß der Schnittlinie A in Figur 2 dargestellt ist,
- Figur 2: eine Draufsicht der Montageplatte,
- Figur 3: eine Draufsicht des Registriergerätes,
- Figur 4: eine Ansicht der Seite des Renkelementes, die dem Registriergerät zugeordnet ist,
- Figur 5: eine Seitenansicht des mittels der erfindungsgemäßen Anordnung funktionsfertig befestigten Registriergerätes,
- Figur 6: eine Seitenansicht des Sperrgliedes,
- Figur 7: eine Draufsicht des Sperrgliedes.

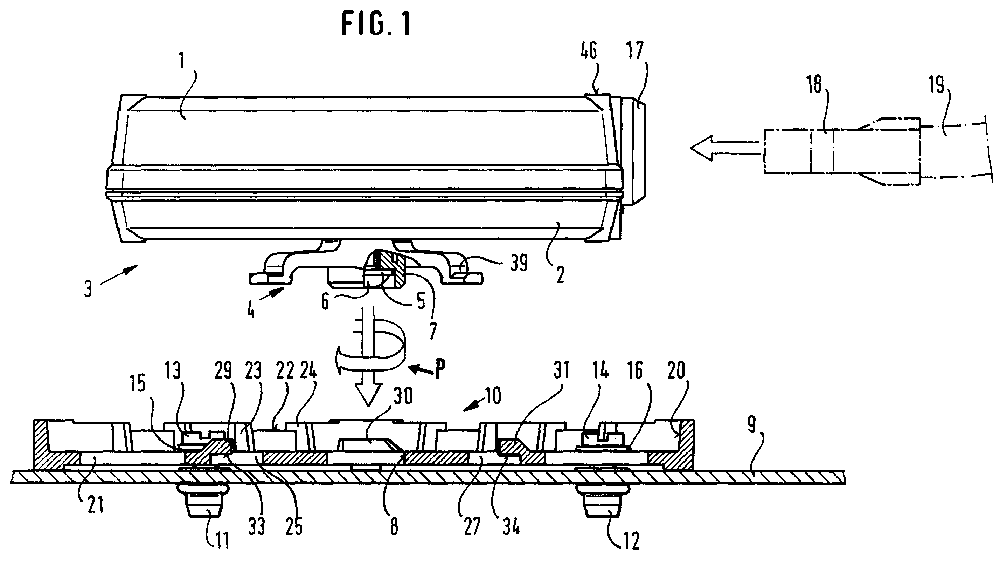

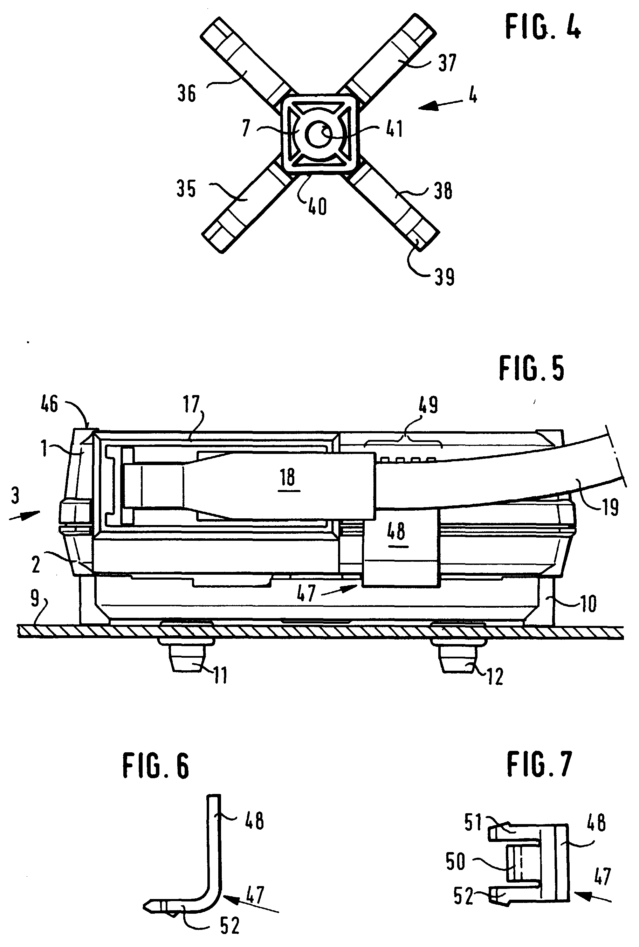

Wie die Übersichtsdarstellung, Figur 1 zeigt, ist einem beispielsweise aus zwei Schalen 1 und 2 gebauten Gehäuse eines elektronischen Registriergerätes 3 ein Renkelement 4 zugeordnet, welches unter Zwischenlage einer Scheibe 5 mittels einer Schraube 6 an dem Gehäuse 1, 2 befestigt ist. Die Schraube 6 ist, wie die Figur 1 ferner zeigt, in der Nabe 7 des Renkelementes 4 versenkt angebracht. Die Nabe 7 hat an der in Figur 1 dargestellten Seite eine zylindrische Ausbildung und dient als Zentrierzapfen im Zusammenwirken mit einer Bohrung 8, welche in einer beispielsweise am Fahrzeugboden 9 befestigten Montageplatte 10 ausgebildet ist. Die Befestigung der Montageplatte 10 erfolgt unter Verwendung von beispielsweise drei in den Fahrzeugboden 9 eingesetzten und in geeigneter Weise abgedichteten Blindnietmutern, von denen in den Figuren 1 und 5 zwei - 11 und 12 - dargestellt sind sowie diesen zugeordneten Schrauben 13 und 14, denen vorzugsweise Zahnscheiben 15 und 16 unterlegt sind. Mit 17 ist ein dem Steckersockel des Registriergerätes 3 zugeordneter Kragen bezeichnet; angedeutet sind in Figur 1 ferner ein mit dem Registriergerät 3 nach dessen Montage an der Montageplatte 10 zu verbindender Stecker 18 und ein mittels des Steckers 18 abgeschlossenes Kabel 19. Bezüglich der Montage sei noch hervorgehoben, daß lediglich eine, der Pfeilekombination P entsprechende bajonettartige Montagebewegung des Registriergerätes 3 erforderlich ist. Dabei ist um eine Montage mit einer Hand zu ermöglichen eine griffgünstige Dimensionierung des Registriergerätes 3 zweckmäßig.

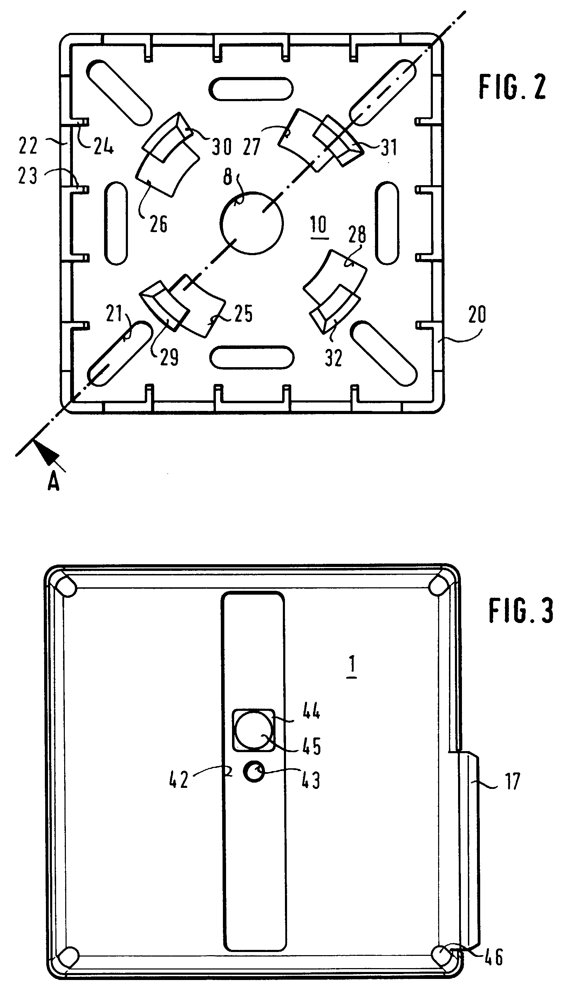

Die Draufsicht der Montageplatte 10, Figur 2, zeigt, daß die Montageplatte 10 mit einem umlaufenden Rand 20 versteift ist und eine Vielzahl von Langlöchern - eines ist mit 21 bezeichnet - aufweist, um die Befestigungsmittel relativ variabel setzen zu können, insbesondere an Einbauorten, an denen für das Gerät selbst nur wenig Anordnungsspielraum besteht. Der Rand 20 ist mehrfach freigespart, die Freisparungen 22 sind von Rippen 23 und 24 flankiert. Die Figur 2 zeigt ferner, daß in der Montageplatte 10 Durchbrüche 25, 26, 27 und 28 vorgesehen und durch Anformen von Verstärkungen 29, 30, 31 und 32 Hinterschnitte, von denen in Figur 1 zwei 33 und 34 sichtbar sind, ausgebildet sind.

Das Renkelement 4 weist, wie insbesondere aus Figur 4 hervorgeht, vier federnd ausgebildete Arme 35, 36, 37 und 38 auf, deren Enden derart abgekröpft ausgebildet sind, daß sie in die Durchbrüche 25, 26, 27, 28 eingreifen können und hinter die Verstärkungen 29, 30, 31, 32 einrenkbar sind. Angeformte Facetten von denen eine mit 39 bezeichnet ist, dienen dem Aufgleiten in die Hinterschnitte 33, 34. Die Figur 4 zeigt ferner, daß die Nabe 7 des Renkelementes 4 auf der dem Registriergerät 3 zugeordneten Seiten mit einem Vierkant 40 versehen ist. Mit 41 ist eine der Schraube 6 zugeordnete Druchgangsbohrung bezeichnet. Der Vierkant 40 dient der formschlüssigen Verbindung mit dem Gehäuse 1, 2, das heißt, mit einer jeweils in den Schalen 1 und 2 ausgebildeten Vertiefung bzw. flachen Nut 42, deren Breite der Seitenlänge des Vierkantes 40 entspricht. Dadurch ist eine Verdrehsicherung zwischen dem Renkelement 4 und dem Gehäuse 1, 2 geschaffen. Mit 43 ist eine der Schraube 6 zugeordnete Gewindebohrung bezeichnet. 44 bezeichnet eine Plombenfassung, 45 eine Plombe, die einer die beiden Schalen 1 und 2 des Gehäuses 1, 2 verbindenden Schraube zugeordnet ist. Da die Nut 42 und die Gewindebohrung 43 jeweils in jeder Schale 1 bzw. 2 des Gehäuses 1, 2 ausgebildet sind, kann je nach den Einbauverhältnissen das Gehäuse 1 2 noch am Einbauort gewendet werden. Um jeweils eine definierte Auflage des Gehäuses 1, 2 auf der Montageplatte 10 zu erzielen sind an beiden Schalen Füße ausgebildet, von denen einer mit 46 bezeichnet ist. Im Zusammenhang mit der Figur 5 sei noch erwähnt, daß insbesondere dann, wenn das Registriergerät 3 als Unfalldatenspeicher dient, eine Zwangsreihenfolge beim Ausbau eingehalten werden sollte damit nicht durch Anstoßen des von der Montageplatte 10 gelösten Registriergerätes 3 bei gestecktem Stecker 18 ungewollt ein Ereignis gespeichert wird. Das heißt, es muß beim Ausbau des Registriergerätes 3 zuerst der Stecker 18 gezogen werden bevor das Registriergerät 3 entnommen werden kann. Hierzu dient ein L-förmiges Sperrglied 47, welches als Verdrehsicherung bezüglich des montierten Registriergerätes 3 dient und welches erst entfernt werden kann, wenn der Stecker 18 gezogen ist, da der Stecker 18 das Sperrglied 47 in geeigneter Weise abdeckt.

Wie die Figuren 6 und 7 zeigen, weist das Sperrglied 47 einen langen Schenkel 48 auf, über den, wenn es zwischen der Montageplatte 10 und dem Registriergerät 3 gesetzt ist, eine Abstützung am Registriergerät 3, und zwar an einer durch mehrere Rippen gebildete Stützfläche 49 erfolgt. Der kurze Schenkel des Sperrgliedes 47 wird von einer Zunge 50, die von Fingern 51 und 52 flankiert ist, gebildet. An der Zunge 50 sowie an den Fingern 51 und 52 sind, wie Figur 7 zeigt, nicht näher bezeichnete Rastnasen angeformt, so daß das Sperrglied selbstsichernd montiert werden kann, wobei es je nach Stellung des Registriergerätes 3 auf der Montageplatte 10 in eine der Freisparungen 22 in der Montageplatte 10 eingeschoben wird. Dabei hintergreifen einerseits die Finger 51, 52 die Rippen 23, 24 seitlich, andererseits übergreift die an der Zunge 50 angeformte Rastnase den umlaufenden Rand 20.

## Patentansprüche

1. Anordnung zum lösbaren Befestigen eines quaderförmigen, elektronischen Registriergerätes mittels einer Montageplatte sowie an der Montageplatte und an dem Registriergerät vorgesehenen Kupplungsmitteln,
**dadurch gekennzeichnet,**
daß die Kupplungsmittel als Renkverbindungsmittel ausgebildet sind.

2. Anordnung nach Anspruch 1,
**dadurch gekennzeichnet,**
daß ein mit dem Registriergerät (3) verbindbares Renkelement (4) vorgesehen ist und in der Montageplatte (10) dem Renkelement (4) zugeordnete Freisparungen (25, 26, 27, 28) ausgebildet sind.

3. Anordnung nach Anspruch 2,
**dadurch gekennzeichnet,**
daß das Renkelement (4) eine Nabe (7) aufweist, an welcher in Achsrichtung federungsfähige Arme (35, 36, 37, 38) radial angeformt sind und
daß an der Nabe (7) eine Dur chgangsbohrung (41) für eine der Befestigung des Renkelementes (4) am Gehäuse (1, 2) des Registriergerätes (3) dienenden Schraube (5) ausgebildet ist.

4. Anordnung nach Anspruch 2,
**dadurch gekennzeichnet,**
daß das Renkelement (4) kraft- und formschlüssig mit dem Gehäuse (1, 2) des Registriergerätes (3) verbindbar ist.

5. Anordnung nach Anspruch 4,
**dadurch gekennzeichnet,**
daß an der Nabe (7) ein Vierkant (40) und im Gehäuse (1, 2) eine dem Vierkant (40) entsprechende Nut (42) ausgebildet sind.

6. Anordnung nach Anspruch 4,
**dadurch gekennzeichnet,**
daß eine Gewindebohrung (43) für die dem Renkelement (4) zugeordnete Schraube (6) und eine dem Vierkant (40) zugeordnete Nut (42) an zwei sich gegenüberliegenden Wänden (Schalen 1 und 2) des Gehäuses (1, 2) ausgebildet sind.

7. Anordnung nach Anspruch 2,
**dadurch gekennzeichnet,**
daß dem zylindrischen Teil der Nabe (7) in der Montageplatte (10) eine Bohrung (8) zugeordnet ist.

8. Anordnung nach Anspruch 1,
**dadurch gekennzeichnet,**
daß dem Registriergerät (3) eine Verdrehsicherung zugeordnet ist, wobei ein L-förmiges Sperrglied (47) vorgesehen ist, welches, wenn es montiert ist, mit dem einen Schenkel (48) am Registriergerät (3) anliegt und mit dem anderen Schenke mit der Montageplatte (10) in Verbindung steht.

9. Anordnung nach Anspruch 8,
**dadurch gekennzeichnet,**
daß der mit der Montageplatte (10) zusammenwirkende Schenkel des Sperrgliedes (47) von einer Zunge (50) und diese flankierenden Fingern (51, 52) gebildet ist und
daß an den Fingern (51, 52) seitlich und an der Zunge (50) parallel zum Scheitel des Sperrgliedes (47) Rastnasen angeformt sind.
